# DEMANDE DE BREVET EUROPEEN

(11) **EP 4 170 730 A1**
(43) Date de publication de la demande: **26.04.2023**
(21) Numéro de dépôt: 22201739.4
(22) Date de dépôt: 14.10.2022
(51) Int. Cl.: H01L 29/78, H01L 21/336, H01L 29/06, H01L 29/08

(54) **DISPOSITIF ÉLECTRONIQUE COMPRENANT DES TRANSISTORS**

(30) Priorité: 20.10.2021 FR 2111151
(71) Demandeur: STMicroelectronics S.r.l., 20864 Agrate Brianza (MB) (IT); STMicroelectronics (Rousset) SAS, 13790 Rousset (FR)
(72) Inventeur: GERMANA-CARPINETO, Rosalia, 06600 ANTIBES (FR); MASOERO, Lia, 13006 MARSEILLE (FR); INNACOLO, Luigi, 95123 CATANIA (IT)
(74) Mandataire: Cabinet Beaumont

(57) **Abrégé**

La présente description concerne un dispositif électronique (100) comprenant un substrat semiconducteur (102) et des transistors dont les grilles (120) sont contenues dans des tranchées (110) s'étendant dans le substrat semiconducteur, chaque transistor comprenant un caisson semiconducteur (130) dopé d'un premier type de conductivité, le caisson étant enterré dans le substrat semiconducteur et au contact de deux tranchées adjacentes parmi lesdites tranchées, une première région semiconductrice (152) dopée d'un deuxième type de conductivité, recouvrant le caisson, au contact du caisson, et au contact des deux tranchées adjacentes, une deuxième région semiconductrice (150) dopée du deuxième type de conductivité plus fortement dopée que la première région semiconductrice, s'étendant dans la première région semiconductrice, et une troisième région semiconductrice (132) dopée du premier type de conductivité, plus fortement dopée que le caisson, recouvrant le caisson, au contact de la première région, et s'étendant dans le substrat semiconducteur au contact du caisson.

## Description

### Domaine technique

La présente description concerne de façon générale les dispositifs électroniques, et plus particulièrement les dispositifs électroniques comprenant des transistors.

### Technique antérieure

Dans certains dispositifs électroniques, des transistors à effet de champ sont utilisés à un état non passant pour bloquer des tensions élevées, typiquement supérieures à 10 V, par exemple de l'ordre de 40 V, voire supérieures à 100 V. De tels transistors à effet de champ sont généralement adaptés pour bloquer une tension drain-source élevée seulement lorsque la tension drain-source est positive. Pour obtenir un blocage d'une tension pouvant être positive ou négative, il peut être nécessaire de disposer deux transistors à effet de champ en antiparallèle. Ceci peut présenter un encombrement important et un coût élevé.

### Résumé de l'invention

Un objet d'un mode de réalisation est de prévoir un dispositif électronique comprenant des transistors palliant tout ou partie des inconvénients des dispositifs électroniques à transistors existants.

Selon un objet d'un mode de réalisation, la surface occupée par les transistors à effet de champ est réduite.

Selon un objet d'un mode de réalisation, le coût de fabrication des transistors à effet de champ est réduit.

Un mode de réalisation prévoit un dispositif électronique comprenant un substrat semiconducteur ayant une première face et des transistors dont les grilles sont contenues dans des tranchées s'étendant dans le substrat semiconducteur, chaque transistor comprenant, dans le substrat semiconducteur, un caisson semiconducteur dopé d'un premier type de conductivité, dans lequel se forme en fonctionnement le canal du transistor, le caisson étant enterré dans le substrat semiconducteur et au contact de deux tranchées adjacentes parmi lesdites tranchées, une première région semiconductrice dopée d'un deuxième type de conductivité, opposé au premier type de conductivité, recouvrant le caisson, au contact du caisson, et au contact des deux tranchées adjacentes, une deuxième région semiconductrice dopée du deuxième type de conductivité plus fortement dopée que la première région semiconductrice, s'étendant dans la première région semiconductrice et exposée sur la première face, et une troisième région semiconductrice dopée du premier type de conductivité, plus fortement dopée que le caisson, recouvrant le caisson, exposée sur la première face, au contact de la première région, et s'étendant dans le substrat semiconducteur au contact du caisson.

Selon un mode de réalisation, la deuxième région semiconductrice est au contact des deux tranchées adjacentes.

Selon un mode de réalisation, la troisième région semiconductrice est au contact des deux tranchées adjacentes.

Selon un mode de réalisation, la première région semiconductrice comprend une première sous-région semiconductrice contenant la deuxième région semiconductrice et au moins une deuxième sous-région semiconductrice exposée sur la première face et reliant la première sous-région semiconductrice à la troisième région semiconductrice, la profondeur maximale de la première sous-région semiconductrice étant supérieure à la profondeur maximale de la deuxième sous-région semiconductrice.

Selon un mode de réalisation, chaque transistor comprend, dans la tranchée contenant la grille du transistor :
- une première couche isolante électriquement entre la grille du transistor et le caisson semiconducteur et formant l'isolant de grille du transistor ;
- un élément conducteur électriquement situé dans la tranchée ;
- une deuxième couche isolante électriquement entre l'élément conducteur électriquement et le substrat semiconducteur ; et
- une troisième couche isolante électriquement entre l'élément conducteur électriquement et la grille.

Selon un mode de réalisation, les deuxièmes régions semiconductrices des transistors sont connectées électriquement ensemble et les troisièmes régions semiconductrices des transistors sont connectées électriquement ensemble.

Selon un mode de réalisation, le substrat semiconducteur comprend une deuxième face opposée à la première face, chaque transistor comprenant en outre, dans le substrat semiconducteur, une quatrième région semiconductrice dopée du deuxième type de conductivité, recouverte par le caisson, au contact du caisson, et une cinquième région semiconductrice dopée du deuxième type de conductivité, plus fortement dopée que la quatrième région semiconductrice, et exposée sur la deuxième face.

Selon un mode de réalisation, le dispositif électronique comprend plusieurs transistors pour chaque paire de tranchées adjacentes, au moins certaines des troisièmes régions semiconductrices des transistors étant alternés avec les deuxièmes régions semiconductrices des transistors.

Selon un mode de réalisation, les caissons de deux transistors adjacents sont jointifs.

Un mode de réalisation prévoit également un procédé de fabrication du dispositif électronique tel que défini précédemment, dans lequel la formation de la première région semiconductrice comprend une étape de formation, par épitaxie, d'une couche semiconductrice dopée du deuxième type de conductivité, et une étape d'implantation de dopants du deuxième type de conductivité dans la couche semiconductrice.

### Brève description des dessins

Ces caractéristiques et avantages, ainsi que d'autres, seront exposés en détail dans la description suivante de modes de réalisation particuliers faite à titre non limitatif en relation avec les figures jointes parmi lesquelles :
la figure 1A est une vue en coupe latérale, partielle et schématique, d'un mode de réalisation d'un dispositif électronique comprenant des transistors ;
la figure 1B est autre vue en coupe latérale, partielle et schématique, du dispositif de la figure 1A ;
la figure 1C est autre vue en coupe latérale, partielle et schématique, du dispositif de la figure 1A ;
la figure 1D est une vue de dessus, partielle et schématique, du dispositif de la figure 1A ;
la figure 2 est une vue en perspective avec coupe, partielle et schématique, du dispositif des figures 1A à 1D ;
la figure 3A est une vue en coupe latérale, partielle et schématique, analogue à la figure 1A illustrant un mode de réalisation des connexions des sources et des caissons des transistors ;
la figure 3B est autre vue en coupe latérale, partielle et schématique, analogue à la figure 1B illustrant un mode de réalisation des connexions des grilles des transistors ;
la figure 4 est une vue de dessus, partielle et schématique, illustrant un mode de réalisation des connexions des transistors ;
la figure 5 est une vue de dessus, partielle et schématique, illustrant un autre mode de réalisation des connexions des transistors ;
la figure 6 illustre une étape d'un mode de réalisation d'un procédé de fabrication du dispositif représenté sur les figures 1A à 1D et 2 ;
la figure 7 illustre une autre étape du procédé ;
la figure 8 illustre une autre étape du procédé ;
la figure 9 illustre une autre étape du procédé ;
la figure 10 illustre une autre étape du procédé ;
la figure 11 illustre une autre étape du procédé ;
la figure 12 illustre, par trois vues, une autre étape du procédé ;
la figure 13 illustre, par trois vues, une autre étape du procédé ;
la figure 14 illustre, par trois vues, une autre étape du procédé ;
la figure 15 est une vue en perspective avec coupe du dispositif représenté sur les figures 1A à 1D illustrant un exemple d'évolution de la concentration de dopants ;
la figure 16 est une vue analogue à la figure 15 selon une autre direction ;
la figure 17 représente des courbes d'évolution de concentrations de dopants obtenues aux étapes de fabrication mises en oeuvre pour obtenir les concentrations de dopants illustrées sur les figures 15 et 16 ;
la figure 18 représente une courbe d'évolution de la résistance à l'état passant Ron d'un transistor du dispositif représenté sur les figures 1A à 1D ;
la figure 19 est une vue en coupe du dispositif représenté sur les figures 1A à 1D illustrant l'évolution de la densité de courant dans une première configuration d'utilisation ;
la figure 20 est une vue en perspective avec coupe du dispositif représenté sur les figures 1A à 1D illustrant l'évolution de la densité de courant dans la première configuration d'utilisation ;
la figure 21 est une vue analogue à la figure 19 dans une deuxième configuration d'utilisation ;
la figure 22 est une vue analogue à la figure 20 dans la deuxième configuration d'utilisation ;
la figure 23 est une vue analogue à la figure 19 dans une troisième configuration d'utilisation ; et
la figure 24 est une vue analogue à la figure 20 dans la troisième configuration d'utilisation.

### Description des modes de réalisation

De mêmes éléments ont été désignés par de mêmes références dans les différentes figures. En particulier, les éléments structurels et/ou fonctionnels communs aux différents modes de réalisation peuvent présenter les mêmes références et peuvent disposer de propriétés structurelles, dimensionnelles et matérielles identiques. Par souci de clarté, seuls les étapes et éléments utiles à la compréhension des modes de réalisation décrits ont été représentés et sont détaillés. En particulier, des étapes de fabrication de masques, des étapes de dopage, et de fabrication de bornes connectées électriquement à des zones dopées ne sont pas détaillées, les modes de réalisation décrits étant compatibles avec des telles étapes usuelles.

Sauf précision contraire, lorsque l'on fait référence à deux éléments connectés entre eux, cela signifie directement connectés sans éléments intermédiaires autres que des conducteurs, et lorsque l'on fait référence à deux éléments reliés (en anglais "coupled") entre eux, cela signifie que ces deux éléments peuvent être connectés ou être reliés par l'intermédiaire d'un ou plusieurs autres éléments. En outre, on considère ici que les termes "isolant" et "conducteur" signifient respectivement "isolant électriquement" et "conducteur électriquement".

Dans la description qui suit, lorsque l'on fait référence à des qualificatifs de position absolue, tels que les termes "avant", "arrière", "haut", "bas", "gauche", "droite", etc., ou relative, tels que les termes "dessus", "dessous", "supérieur", "inférieur", etc., ou à des qualificatifs d'orientation, tels que les termes "horizontal", "vertical", etc., il est fait référence sauf précision contraire à l'orientation des figures ou à un écran d'affichage dans une position normale d'utilisation.

Sauf précision contraire, les expressions "environ", "approximativement", "sensiblement", et "de l'ordre de" signifient à 10 % près, de préférence à 5 % près. Sauf précision contraire, les adjectifs numéraux ordinaux, tels que "premier", "deuxième", etc., sont utilisés seulement pour distinguer des éléments entre eux. En particulier, ces adjectifs ne limitent pas les modes de réalisation décrits à un ordre particulier de ces éléments.

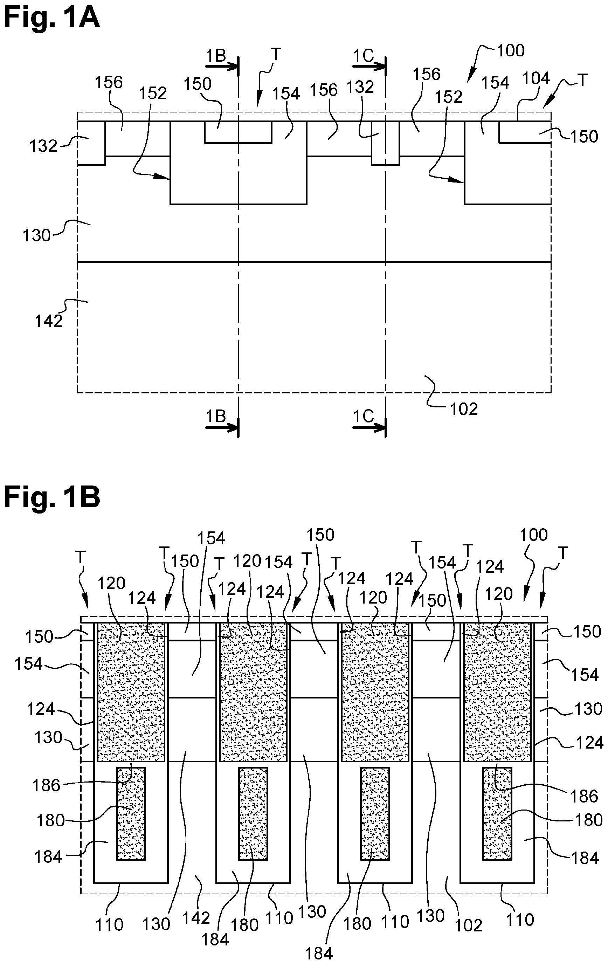

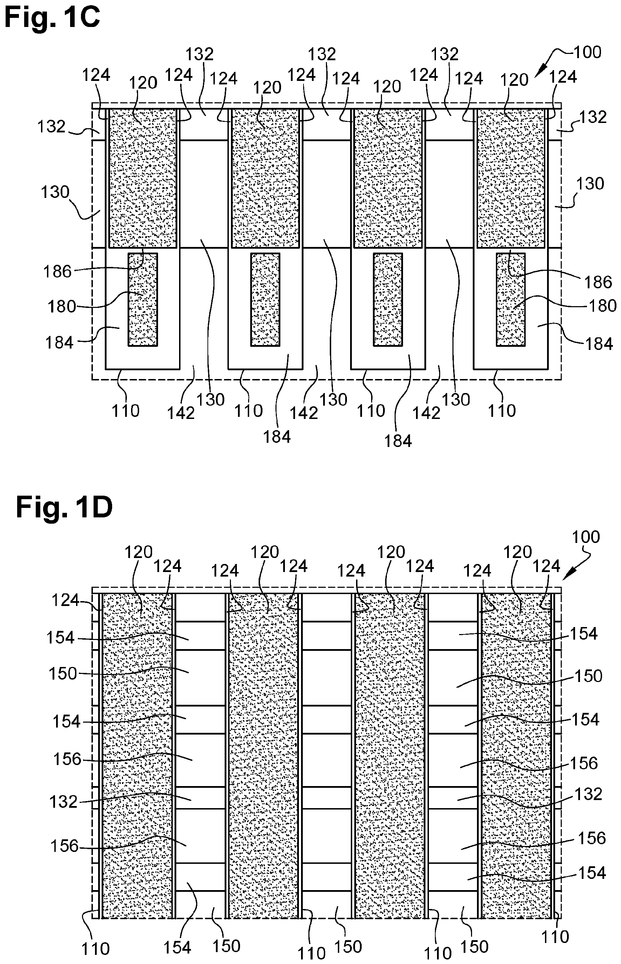

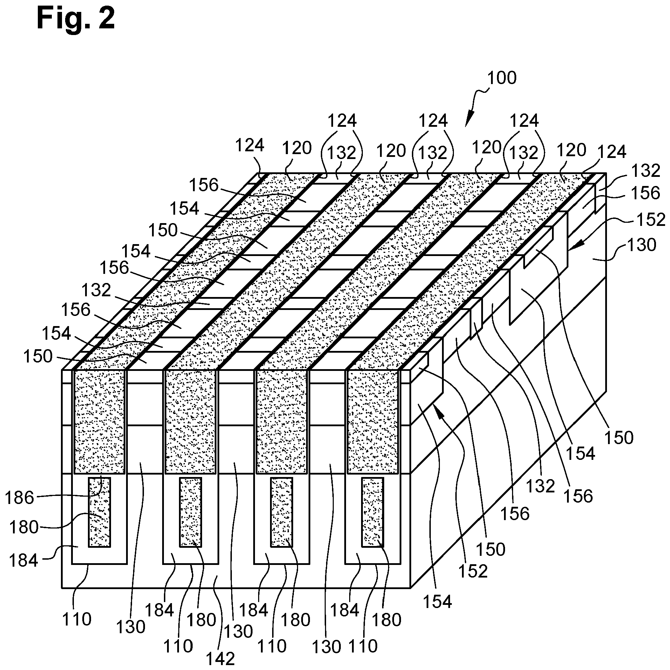

Les figures 1A, 1B, 1C, et 1D représentent, de manière partielle et schématique, respectivement des vues en coupe et une vue de dessus, et la figure 2 est une vue en perspective d'un mode de réalisation d'un dispositif 100 comprenant plusieurs transistors T. Les vues en coupe 1B et 1C ont pour plans de coupe respectifs des plans parallèles 1B-1B et 1C-1C. Les transistors T sont représentés partiellement sur les figures 1A à 1D et 2.

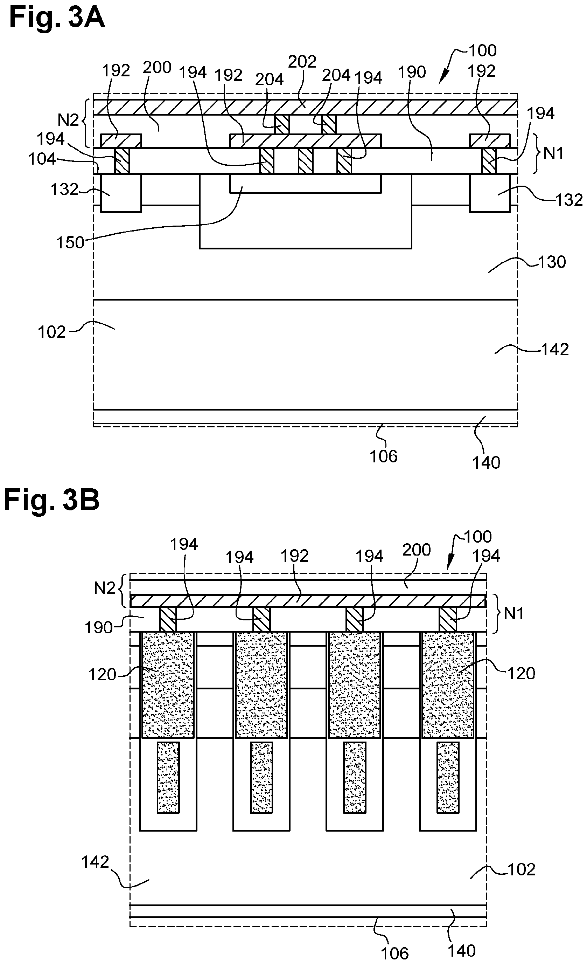

Le dispositif 100 est typiquement une puce électronique de circuit intégré, définie par un substrat semiconducteur 102 comprenant une face avant 104 et une face arrière 106, non visible sur les figures 1A à 1D et 2 et visible sur les figures 3A et 3B décrites par la suite, opposée à la face avant 104, et des transistors T situés dans et sur le substrat 102.

Les transistors T sont délimités par des tranchées 110, quatre tranchées 110 parallèles étant représentées à titre d'exemple sur les figures 1B à 1D et 2. Chaque tranchée 110 s'étend dans le substrat 102 à partir de la face avant 104 sur une partie de l'épaisseur du substrat 102.

Chaque transistor T comprend notamment :
- une grille 120 située dans l'une des tranchées 110 ;
- un caisson semiconducteur 130 dopé d'un premier type de conductivité, enterré dans le substrat 102, séparé de la grille 120 par un isolant de grille 124, et dans lequel se forme en fonctionnement le canal du transistor T. Le caisson 130 est reliée à la face avant 104 par une zone semiconductrice de prise de contact 132 s'étendant dans le substrat 102 depuis la face avant 104 ;
- des zones semiconductrices dopées 140 et 150 de drain/source, dopées d'un deuxième type de conductivité, opposé au premier type de conductivité, et situées de part et d'autre du caisson 130. La zone dopée 140, également appelée région de drain, non visible sur les figures 1A à 1D et 2 et visible sur les figures 3A et 3B décrites par la suite, est en contact avec la face arrière 106 du substrat 102, et la zone dopée 150, également appelée région de source, est en contact avec la face avant 104 du substrat 102 ; et
- des régions semiconductrices 142, 152 dite régions de dérive, dopées du deuxième type de conductivité et moins fortement dopées que les zones dopées 140 et 150. La région de dérive 142 est interposée entre la zone dopée 140 et le caisson 130 et la région semiconductrice 152 est interposée entre la zone dopée 150 et le caisson 130.

Chaque transistor T défini par les éléments décrits ci-dessus constitue ainsi un transistor à effet de champ, c'est-à-dire un composant électronique susceptible, en fonction d'une tension de commande appliquée entre la grille 120 et la région de source 150, de former, dans le caisson 130, un canal conducteur connectant électriquement les régions de drain et de source 140 et 150.

La grille 120 de chaque transistor T comprend au moins une région conductrice électriquement s'étendant dans l'une des tranchées 110, tel que par exemple un métal et/ou du silicium polycristallin dopé, une paroi latérale de la tranchée 110 constituant une face latérale du caisson 130 du transistor T. L'isolant de grille 124, recouvrant la paroi latérale de la tranchée 110, est en contact avec le caisson 130 et avec la région conductrice de la grille 120. L'isolant de grille 124 est typiquement constitué d'une ou plusieurs couches diélectriques, par exemple l'isolant de grille est constitué d'une couche d'oxyde de silicium. L'épaisseur de l'isolant de grille 124 est typiquement inférieure à 15 nm, de préférence comprise entre 20 nm et 40 nm.

Le nombre et les dimensions des tranchées 110 dépendent de l'application envisagée. La profondeur de chaque tranchée 110 peut être comprise entre 1,7 µm et 2,5 µm, par exemple égale à environ 2 µm. A titre d'exemple, chaque tranchée 110 peut avoir une largeur comprise entre 0,1 µm et 1 µm, par exemple égale à 0,6 µm. De préférence, les tranchées 110 s'étendent au moins en partie selon des directions parallèles à une même direction, appelée direction longitudinale de tranchée par la suite, et sont espacées de façon régulière. On appelle par la suite direction latérale de tranchée la direction perpendiculaire à la direction longitudinale de tranchée. Le pas des tranchées selon la direction latérale de tranchée peut être compris entre 0,9 µm et 1,2 µm. Le nombre de tranchées 110 peut varier de 1000 à 3000. La longueur de chaque tranchée 110selon la direction longitudinale de tranchée peut varier de 0,5 µm à 3 µm.

Selon un mode de réalisation, comme cela apparaît sur les figures 1B et 2, chaque tranchée 110 d'un ensemble de tranchées 110 adjacentes et parallèles, éventuellement à l'exception des tranchées 110 situées aux deux bords opposés de l'ensemble de tranchées 110, délimite des transistors T de part et d'autre de la tranchée 110. Selon un mode de réalisation, comme cela apparaît sur les figures 1D et 2, pour chaque tranchée 110, les grilles 120 contenues dans la tranchée 110 sont connectées les unes aux autres et forment une grille 120 commune aux transistors T qui sont délimités par cette tranchée 110. Selon un mode de réalisation, pour chaque tranchée 110, les caissons semiconducteurs 130 des transistors T qui sont délimités par cette tranchée 110 et situés d'un même côté de cette tranchée 110 sont jointifs et forment un caisson semiconducteur continu 130.

Dans un exemple, le substrat 102 est constitué par une tranche semiconductrice, par exemple une tranche de silicium. Dans un autre exemple, le substrat est constitué par une couche située sur la surface d'une tranche semiconductrice, par exemple une couche épitaxiée sur une tranche semiconductrice. De préférence, le substrat 102 est monocristallin.

Selon un mode de réalisation, comme cela apparaît sur les figures 1B et 1C, chaque caisson 130 situé entre des première et deuxièmes tranchées 110 adjacentes s'étend de la première tranchée 110, au contact de l'isolant de grille 124 recouvrant la paroi latérale de la première tranchée 110, jusqu'à la deuxième tranchée, au contact de l'isolant de grille 124 recouvrant la paroi latérale de la deuxième tranchée 110. La profondeur, mesurée depuis la face avant 104, de la zone de prise de contact 132 peut être comprise entre 0,4 µm et 0,8 µm. La profondeur maximale, mesurée depuis la face avant 104, du caisson 130 peut être comprise entre 0,8 µm et 1,2 µm. L'épaisseur, mesurée selon une direction orthogonale à la face avant 104, du caisson 130 sous la région de dérive 152 peut être comprise entre 0,5 µm et 0,8 µm. L'épaisseur maximale, mesurée selon une direction orthogonale à la face avant 104, du caisson 130 peut être comprise entre 1 µm et 1,3 µm. La dimension selon la direction longitudinale de tranchée de la zone de prise de contact 132 peut être comprise entre 0,5 µm et 1,5 µm.

Selon un mode de réalisation, comme cela apparaît sur la figure 1D, chaque région de dérive 152 situé entre des première et deuxièmes tranchées 110 adjacentes s'étend de la première tranchée 110, au contact de l'isolant de grille 124 recouvrant la paroi latérale de la première tranchée 110, jusqu'à la deuxième tranchée, au contact de l'isolant de grille 124 recouvrant la paroi latérale de la deuxième tranchée 110. La région de dérive 152 comprend une première sous-région de dérive 154 et deux deuxièmes sous-régions de dérive 156, connectées à la première sous-région de dérive 154. La première sous-région de dérive 154 est moins fortement dopée que la région de source 150. Les deuxièmes sous-régions de dérive 156 sont moins fortement dopées que la région de source 150, et de préférence moins fortement dopées que la première sous-région de dérive 154. Chacune de la première sous-région de dérive 154 et des deuxièmes sous-régions de dérive 156 situées entre des première et deuxièmes tranchées 110 adjacentes s'étend de la première tranchée 110, au contact de l'isolant de grille 124 recouvrant la paroi latérale de la première tranchée 110, jusqu'à la deuxième tranchée, au contact de l'isolant de grille 124 recouvrant la paroi latérale de la deuxième tranchée 110. La région de source 150 est contenue dans la première sous-région de dérive 154. La première sous-région de dérive 154 recouvre la totalité du fond de la région de source 150. La première sous-région de dérive 154 recouvre la totalité des parois latérales de la région de source 150 entre les première et deuxième tranchées 110. Les deuxièmes sous-régions de dérive 156 sont situées de part et d'autre de la première sous-région de dérive 154 selon la direction longitudinale de tranchée. Chaque deuxième sous-région de dérive 156 s'étend, selon la direction longitudinale de tranchée, de la première sous-région de dérive 154 à la zone de prise de contact 132 adjacente. Chaque deuxième sous-région de dérive 156 peut être exposée sur la face avant 104 du substrat 102. De préférence, la région de source 150 s'étend de la première tranchée 110, au contact de l'isolant de grille 124 recouvrant la paroi latérale de la première tranchée 110, jusqu'à la deuxième tranchée, au contact de l'isolant de grille 124 recouvrant la paroi latérale de la deuxième tranchée 110

La profondeur de la première sous-région de dérive 154 peut être comprise entre 0,4 µm et 0,6 µm. La profondeur de chaque deuxième sous-région de dérive 156 peut être comprise entre 0,3 µm et 0,6 µm. La dimension maximale selon la direction longitudinale de tranchée de la région de dérive 152 peut être comprise entre 2 µm et 5 µm. La dimension selon la direction longitudinale de tranchée de la première sous-région de dérive 154 peut être comprise entre 1,5 µm et 4 µm. La dimension selon la direction longitudinale de tranchée de chaque deuxième sous-région de dérive 156 peut être comprise entre 0,5 µm et 1 µm. La profondeur, mesurée depuis la première face 104, de la région de source 150 peut être comprise entre 0,2 µm et 0,4 µm.

A titre d'exemple, le transistor T est du type à canal N. Ainsi, les zones dopées 140 et 150 sont dopées de type N. Le caisson 130 est dopé de type P. Cependant, dans les modes de réalisation décrits, les types de conductivité N et P, ou types de dopage, peuvent être échangés. Des fonctionnements similaires à ceux décrits sont alors obtenus en échangeant les signes des tensions dans le dispositif.

De préférence, les niveaux de dopage des zones 140 et 150 sont élevés, c'est-à-dire supérieurs à 5*10¹⁸ atomes/cm³, de préférence supérieurs à 10¹⁹ atomes/cm³. La prise de contact 132, connectée électriquement au caisson 130, est une zone dopée ayant également un tel niveau de dopage élevé. Le niveau de dopage du caisson 130 est de préférence inférieur à 10¹⁸ atomes/cm³, plus préférentiellement inférieur à 5*10¹⁷ atomes/cm³. Chaque région de dérive 142, 152 a un niveau de dopage inférieur à celui de la zone dopée 150. De préférence, chaque région semiconductrice 142, 152 a un niveau de dopage faible, c'est-à-dire inférieur à 2*10¹⁷ atomes/cm³. Ce niveau de dopage est de préférence supérieur à 5*10¹⁶ atomes/cm³. Selon un mode de réalisation, chaque première sous-région de dérive 154 a un niveau de dopage compris entre 2*10¹⁷ atomes/cm³ et 6*10¹⁷ atomes/cm³. Selon un mode de réalisation, chaque deuxième sous-région de dérive 156 a un niveau de dopage compris entre 3*10¹⁶ atomes/cm³ et 1*10¹⁷ atomes/cm³.

Le dispositif 100 peut comprendre, en outre, pour chaque tranchée 110, un élément électriquement conducteur 180 situé dans la tranchée 110. L'élément conducteur 180 est connecté à une borne non représentée sur les figures 1A à 1D et 2. Cette borne est de préférence connectée aux zones de prises de contact 132. L'élément conducteur 180 est situé en vis-à-vis d'au moins une partie de la région semiconductrice 142, c'est-à-dire que l'élément conducteur 180 est situé contre un isolant 184 recouvrant la face latérale d'au moins une partie de la région semiconductrice 142. La couche isolante 184 sépare l'élément conducteur 180 de la région semiconductrice 142. La distance entre l'élément conducteur 180 et la région semiconductrice 142, correspondant à l'épaisseur de la couche isolante 184, est par exemple comprise entre 100 nm et 200 nm, de préférence, comprise entre 120 nm et 180 nm. La couche isolante 184 a de préférence une épaisseur supérieure à celle de l'isolant de grille 124. A titre d'exemple, la couche isolante 184 est en oxyde de silicium ou en nitrure de silicium.

Au fond de la tranchée 110, une portion isolante, de préférence une portion de la couche isolante 184, est située sous l'élément conducteur 180. Cette portion isole électriquement l'élément conducteur 180 de la partie du substrat 102 située sous l'élément conducteur 180. En outre, des couches isolantes 186, de préférence du même matériau ou matériaux que l'isolant de grille 124, isolent électriquement l'élément conducteur 180 de la grille 120.

De préférence, l'élément conducteur 180 est constitué par un mur conducteur situé dans une partie centrale de la tranchée 110. Le mur est allongé dans la même direction que la tranchée. Le mur s'étend dans le substrat 102 orthogonalement à la face avant 104 du substrat. A titre d'exemple, le mur comprend, de préférence est constitué par, un matériau métallique ou, préférentiellement, du silicium polycristallin dopé. La largeur du mur conducteur, prise dans la direction transversale de tranchée, est par exemple comprise entre 30 nm et 200 nm.

Le dispositif 100 comprend en outre des pistes conductrices et des vias conducteurs, non représentés sur les figures 1A à 1D et 2, d'au moins un niveau de métallisation formé sur la face avant 104 du substrat 102 pour la connexions des sources, des grilles, et des caissons des transistors T. Selon un mode de réalisation, les régions de source 150 de l'ensemble des transistors MOS sont connectées ensemble. Selon un mode de réalisation, les grilles 120 présentes dans les tranchées 110 sont connectées ensemble. Selon un mode de réalisation, les zones de prise de contact 132 des caissons 30 sont connectées ensemble.

Les figures 3A et 3B sont des vues analogues respectivement aux figures 1A et 1B illustrant un mode de réalisation des connections des transistors T.

A titre d'exemple, le dispositif 100 est représenté sur les figures 3A et 3B avec deux niveaux de métallisation N1 et N2. Le premier niveau de métallisation N1 comprend une couche isolante 190 recouvrant la face avant 104 du substrat 102, des pistes métalliques 192 s'étendant sur la couche isolante 190, et des vias conducteurs 194 traversant la couche isolante 190 et connectant les pistes métalliques 192 notamment aux grilles 120, aux régions de source 150, et aux zones de prises de contact 132. Le deuxième niveau de métallisation N2 comprend une couche isolante 200 recouvrant les pistes conductrices 192 et la couche isolante 190 entre les pistes conductrices 192, des pistes métalliques 202 s'étendant sur la couche isolante 200, et des vias conducteurs 204 traversant la couche isolante 200 et connectant les pistes métalliques 202 à au moins certaines des pistes métalliques 192.

Le nombre de transistors T montés en parallèle dépend de l'application visée. Selon un mode de réalisation, le dispositif 100 comprend de 3*10⁵ à 3*10⁶ transistors T.

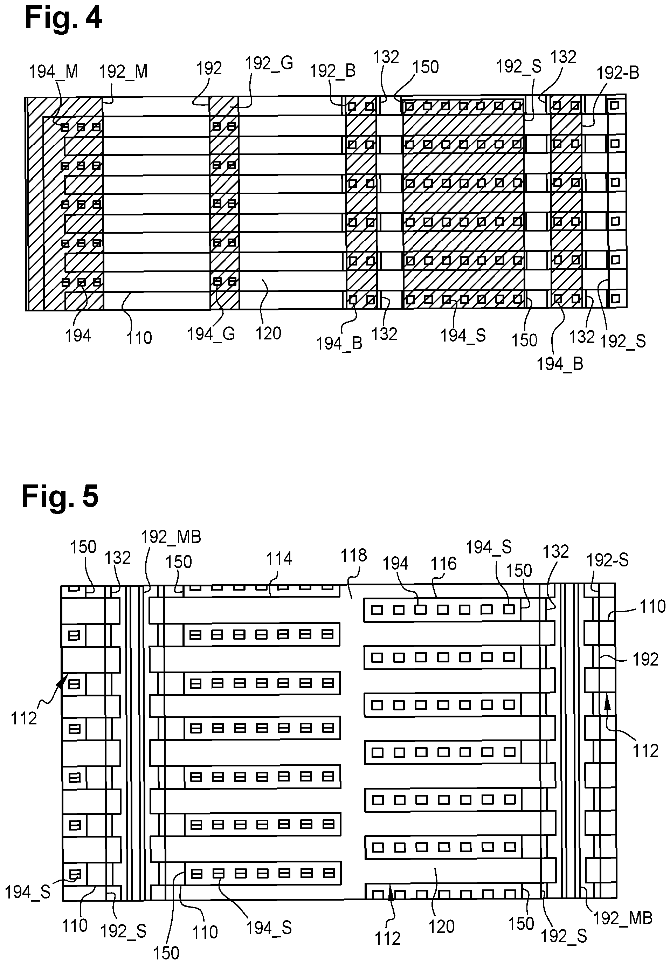

La figure 4 est une vue de dessus d'un mode de réalisation illustrant un agencement des pistes conductrices 192 du premier niveau de métallisation qui ont la forme de bandes parallèles et de plaques. On a en outre représenté en figure 4 les limites des tranchées 110, des zones de prise de contact 132, et des régions de source 150. Les vias conducteurs 194 sont en outre représentés par des carrés éventuellement traversés d'un trait horizontal. Dans le présent mode de réalisation, les tranchées 110 sont parallèles et s'étendent sans interruption sur la totalité de la région où les transistors sont formés. Comme cela est représenté en figure 4, les pistes conductrices 192 se répartissent en plaques conductrices 192_S reliées aux régions de source 150 par des vias conducteurs 194_S, en pistes conductrices 192_B reliées aux zones de prise de contact 132 par des vias 194_B, en une piste conductrice 192_G reliée aux grilles 120 par des vias 194_G, et en une piste conductrices 192_M reliée aux éléments conducteurs 180 par des vias 194_M. Dans le présent mode de réalisation, les plaques 192_S sont alternées avec les bandes 192_B. Les pistes conductrices 202 du deuxième niveau de métallisation, non représentées en figure 4, peuvent être utilisées pour la connexion des plaques conductrices 192_S.

La figure 5 est une vue de dessus d'un mode de réalisation illustrant un autre agencement des pistes conductrices 192 du premier niveau de métallisation qui ont la forme de bandes parallèles et de plaques. On a en outre représenté en figure 5 les limites des tranchées 110, des zones de prise de contact 132, et des régions de source 150. Dans le présent mode de réalisation, les tranchées 110 sont parallèles et s'étendent et sont répartis en ensembles 112 de tranchées 110 sur la région où les transistors sont formés, chaque ensemble 112 de tranchées comprend des premier et deuxième groupes 114, 116 de tranchées 110, les tranchées du premier groupe 114 étant décalées selon la direction transversale de tranchée par rapport aux tranchées 110 du deuxième groupe 116 de la moitié du pas des tranchées, les tranchées des premier et deuxième groupe étant reliée à une extrémité à une tranchée 118 s'étendant selon la direction transversale de tranchée. Les vias conducteurs 194 sont représentés par des carrés éventuellement traversés d'un trait horizontal. Comme cela est représentés en figure 5, les pistes conductrices 192 se répartissent en plaques conductrices 192_S reliées aux régions de source 150 par des vias conducteurs 194_S, en pistes conductrices 192_MB reliées aux zones de prise de contact 132 et aux éléments conducteurs 180 par des vias 194_MB. La connexion des grilles 120 peut être réalisée dans une zone en dehors de la figure 5.

A titre d'exemple, pour une application dans le domaine des relais intégrés de forte puissance, le drain des transistors T peut être amené en fonctionnement à un potentiel de 40 V à 45 V. Lorsque les transistors T sont à l'état passant, la tension entre la grille et la source de chaque transistor T est d'environ 10 V et le potentiel à la source est d'environ 40 V-45 V. Lorsque les transistors T sont à l'état non passant, la tension entre la grille et la source de chaque transistor T est d'environ 0 V et le potentiel à la source est d'environ 0 V. Les zones de prise de contact 132 des caissons 130 sont mises à 0 V et les éléments conducteurs 180 sont mis à 0 V.

La présence des éléments conducteurs 180 permet de façon avantageuse de réduire l'intensité du champ électrique présent en fonctionnement au niveau des jonctions P-N. Ceci permet d'augmenter la concentration de dopants de la région de dérive 142 et 152 tout en assurant que le transistor ne soit pas détérioré lors de l'application de tensions maximales.

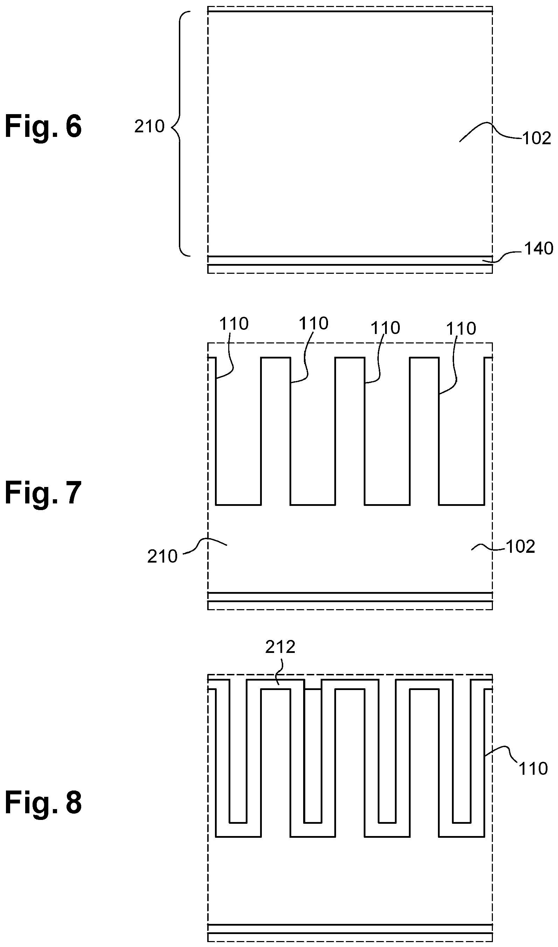

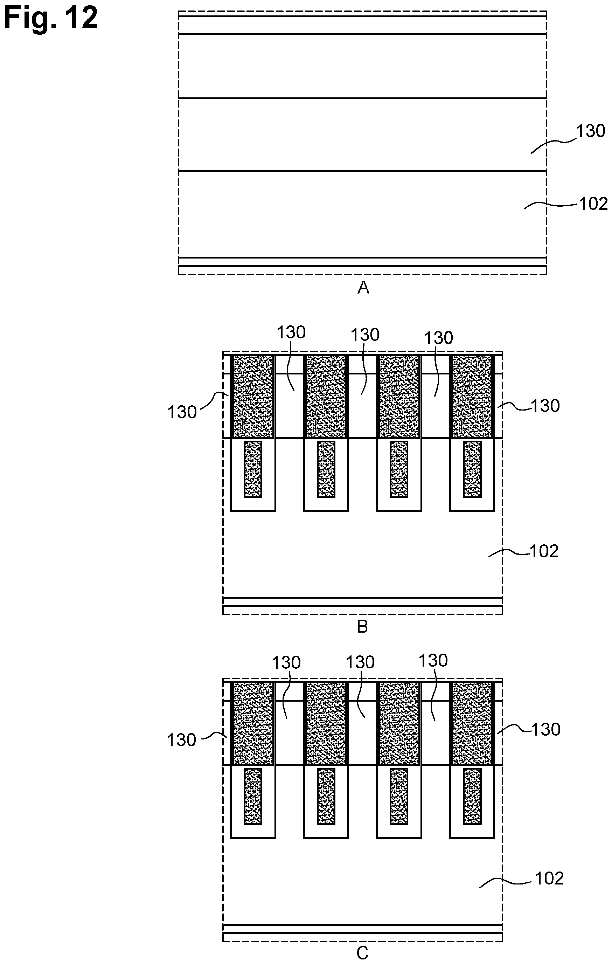

Les figures 6 à 14 sont des vues en coupe, partielles et schématiques, de structures obtenues à des étapes d'un mode de réalisation d'un procédé de fabrication du dispositif 100 des figures 1A à 1D. Pour les figures 12, 13, et 14, on a représenté trois vues en coupe A, B, et C analogues aux vues en coupe 1A, 1B, et 1C.

La figure 6 représente la structure obtenue après la formation dans le substrat 102 de la région de drain 140 fortement dopée du deuxième type de conductivité, par exemple dopée de type N, et d'une couche semiconductrice 210 plus faiblement dopée que la région de drain 140, dont la concentration de dopants correspond sensiblement à la concentration de dopants souhaitée pour la région de dérive 142. Le substrat 102 peut être fabriqué par la formation, sur une tranche de silicium fortement dopée, ce qui correspond à la région de drain 140, de la couche semiconductrice 210 de silicium plus faiblement dopée, par exemple par épitaxie.

La figure 7 représente la structure obtenue après la formation des tranchées 110 dans la couche 310 du substrat 102. Les tranchées 110 peuvent être réalisées par une étape de gravure.

La figure 8 représente la structure obtenue après la formation, sur les parois et le fond de chaque tranchée 110, d'une couche isolante 212. Le procédé peut comprendre un dépôt conforme d'une couche isolante recouvrant la structure résultant de la gravure des tranchées 110. La composition et l'épaisseur de la couche isolante 212 correspondent à la composition et l'épaisseur souhaitées pour la couche isolante 184. A titre de variante, la couche isolante 212 peut être formée par une étape d'oxydation thermique.

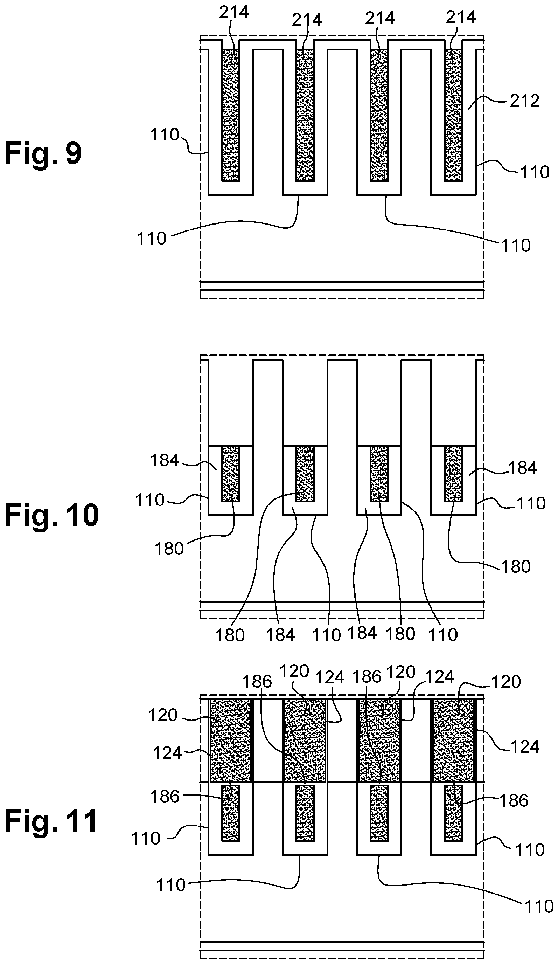

La figure 9 représente la structure obtenue après la formation dans chaque tranchée 110 d'un coeur conducteur 214. Le procédé peut comprendre le dépôt d'une couche conductrice, par exemple en silicium polycristallin, recouvrant la couche isolante 212 et remplissant l'espace restant de chaque tranchée 110, et le retrait, par exemple par gravure, des parties de la couche conductrice situées en dehors des tranchées 110. La composition des coeurs conducteurs 214 correspond à la composition souhaitée des éléments conducteurs 180.

La figure 10 représente la structure obtenue après la gravure, sur une partie de la profondeur de chaque tranchée 110, de la couche isolante 212 et du coeur conducteur 214. Les éléments conducteurs 180 et les couches isolantes 184 des transistors sont ainsi formés.

La figure 11 représente la structure obtenue après la formation, dans chaque tranchée 110, de la couche isolante 186, de l'isolant de grille 124 et de la grille 120. L'isolant de grille 124 peut être formé par oxydation thermique. Le procédé peut comprendre un dépôt d'une couche conductrice recouvrant la couche isolante et remplissant l'espace restant de chaque tranchée 110, et le retrait, par exemple par gravure, des parties de la couche conductrice situées en dehors des tranchées 110.

La figure 12 représente, sur des vues en coupe 12A, 12B, et 12C, la structure obtenue après une étape d'implantation de dopants du premier type de conductivité, par exemple de type P, pour former les caissons 130 des transistors, enterrés dans le substrat 102.

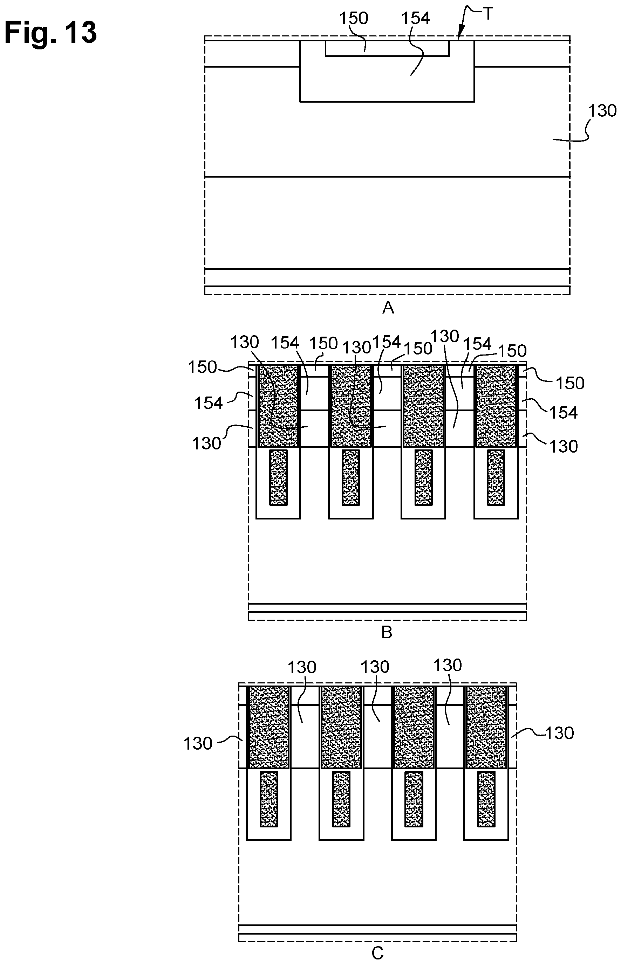

La figure 13 représente, sur des vues en coupe 13A, 13B, et 13C, la structure obtenue après une première étape d'implantation de dopants du deuxième type de conductivité, pour former, pour chaque transistor T, la première sous-région de dérive 154, et une deuxième étape d'implantation de dopants du deuxième type de conductivité, pour former, pour chaque transistor T, la région de source 150.

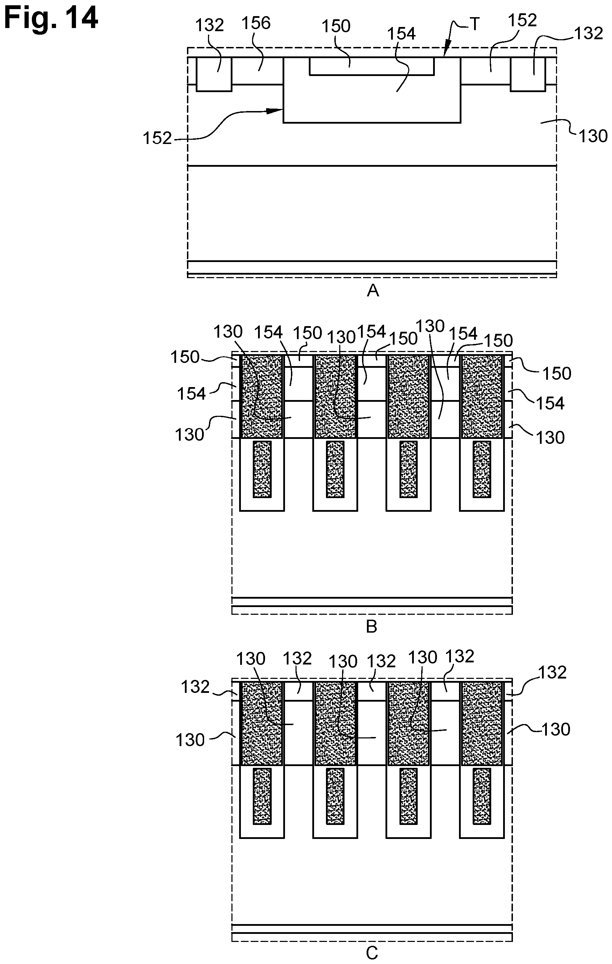

La figure 14 représente, sur des vues en coupe 14A, 14B, et 14C, la structure obtenue après une étape d'implantation de dopants d'un premier type de conductivité pour former les zones de prise de contact 132. Ceci délimite en outre, pour chaque transistor T, les deuxièmes sous-régions de dérive 156 des régions de dérive 152. Les transistors T sont ainsi formés.

Le procédé se poursuit par la formation des niveaux de métallisation.

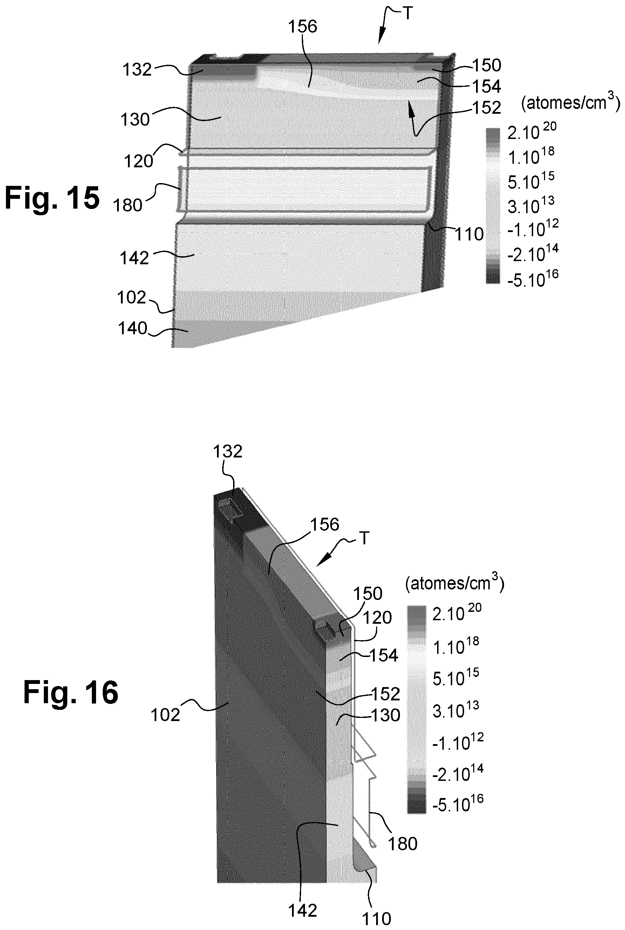

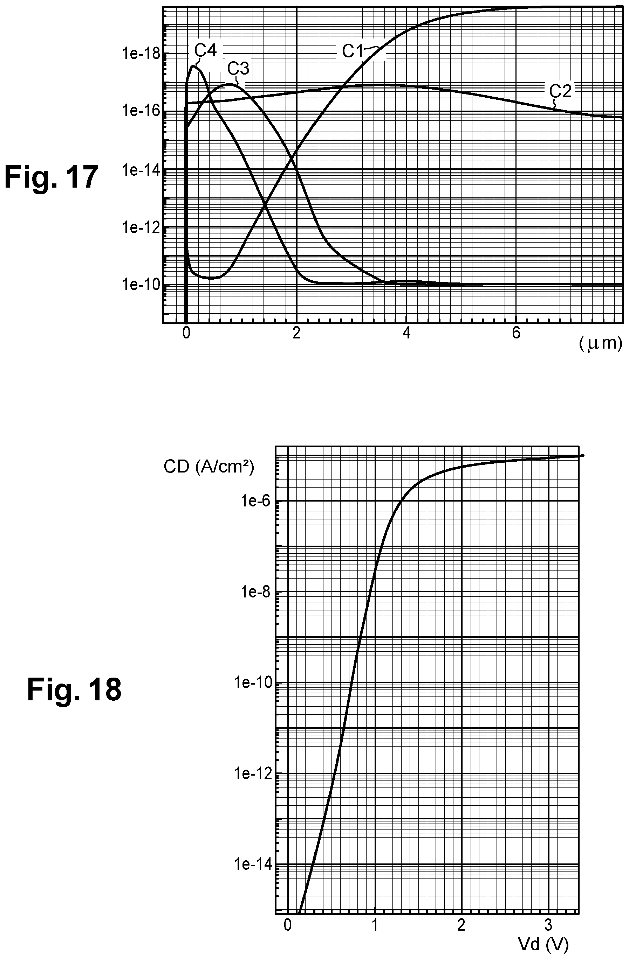

Les figures 15 et 16 sont des vues en perspective avec coupe selon deux directions différentes illustrant l'évolution de la concentration de dopants en niveaux de gris dans le dispositif 100 des figures 1A à 1D fabriqué selon le mode de réalisation du procédé de fabrication décrit précédemment en relation avec les figures 6 à 14 avec les profils de concentrations de dopants illustrés sur la figure 17. Sur les figures 15 et 16, la teinte de gris est d'autant plus foncée que la concentration de dopants de type N ou P est élevée. Sur les figures 15 et 16, seul le substrat semiconducteur 102 est représenté et les éléments d'un seul transistor T sont partiellement représentés. Les contours de la grille 120, de l'élément conducteur 180, et des vias 194 connectés à la région de source 150 et la zone de prise de contact 132 du transistor T sont en outre partiellement représentés.

Sur la figure 17, les courbes C1, C2, C3, et C4 sont des profils de concentrations de dopants, exprimés en atomes/cm³, dans le substrat 102 en fonction de la profondeur mesurée depuis la face avant 104 au niveau d'une région de source 150. En particulier le substrat 102 peut être fabriqué par la formation, sur une tranche de silicium fortement dopée à l'arsenic (dopant de type N), ce qui correspond à la région de drain 140, et de la couche semiconductrice 210 de silicium plus faiblement dopée au phosphore (dopant de type N), par exemple par épitaxie. La courbe C1 est la courbe d'évolution de la concentration d'arsenic (présente dans le substrat 102) et la courbe C2 est la courbe d'évolution de la concentration de phosphore issu de la formation de la couche 210. La courbe C3 est la courbe d'évolution de la concentration de bore (dopant de type P) obtenue après l'étape d'implantation pour la formation du caisson 130. La courbe C4 est la courbe d'évolution de la concentration de phosphore obtenue après l'étape d'implantation pour la formation de la première sous-région de dérive 154. La courbe d'évolution, non représentée en figure 5, de la concentration de phosphore obtenue après l'étape d'implantation de phosphore pour la formation de la région de source 150 présente un pic à environ 2*10¹⁹ atomes/cm³ à une profondeur d'environ 50 nm et chute à moins de 1*10¹⁵ atomes/cm³ à une profondeur supérieure à 350 nm. Comme cela apparaît sur les figures 15 et 16, la concentration de dopants de type N évolue de façon continue entre les première et deuxième sous-régions de dérive 154, 156 et la région de source 150.

Des simulations ont été réalisées pour le dispositif 100 représenté sur les figures 1A à 1D pour mettre en évidence les propriétés des transistors T. Pour les simulations, le dispositif 100 comprenait les concentrations de dopants décrites précédemment en relation avec les figures 15 à 17. Les simulations correspondent aux situations de fonctionnement normal du transistor T et des conditions de potentiels défavorables pour les jonctions P-N du transistor T. Les simulations ont été réalisées pour une température de 25 °C.

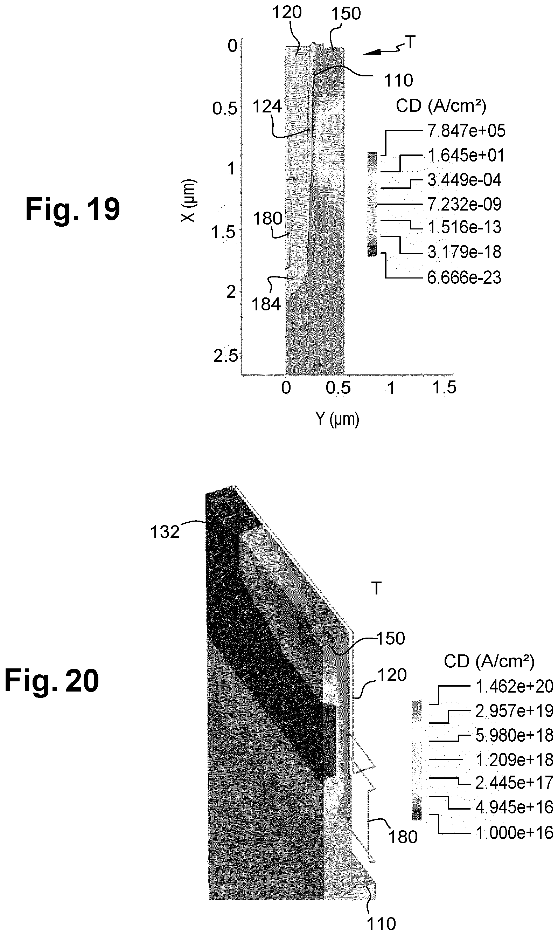

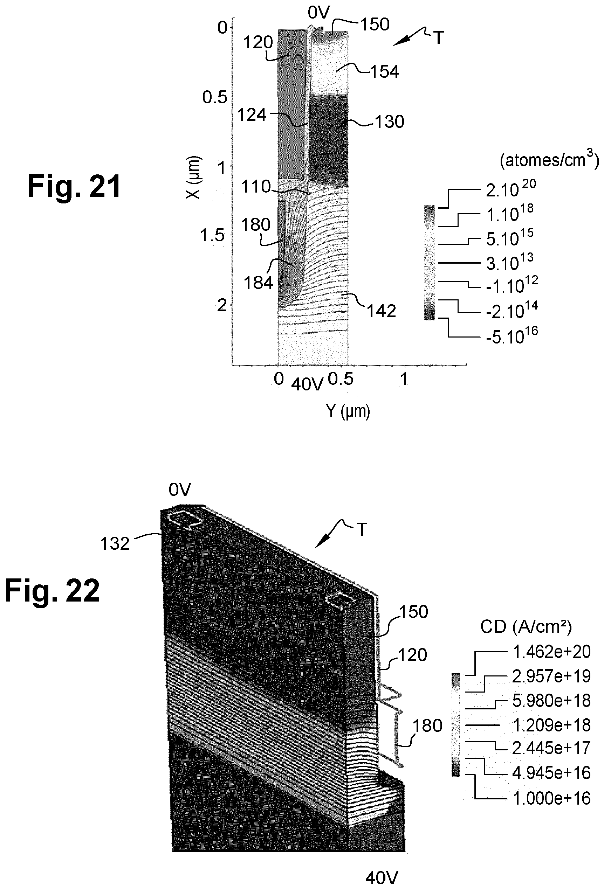

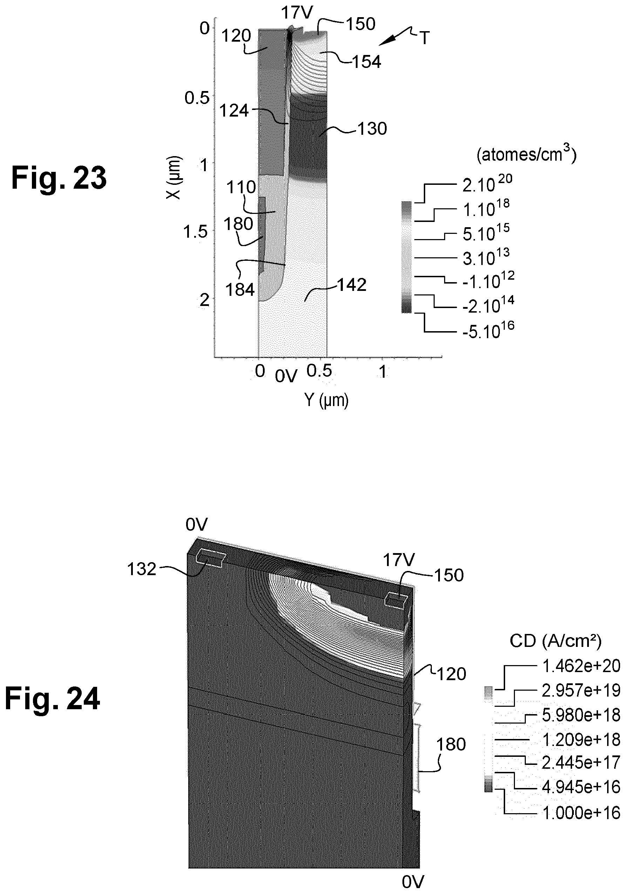

La figure 18 représente une courbe d'évolution de la densité de courant CD, exprimée en A/cm², en fonction de la tension de drain Vd, exprimée en volts, circulant dans la région de drain 140 du transistor T à l'état passant. Les figures 19, 21, et 23 sont des vues en coupe latérale d'une partie d'un transistor T et les figures 20, 22, et 24 sont des vues en perspective avec coupe d'une partie d'un transistor T. Les figures 19, 20, 22, et 24 illustrent l'évolution de la densité de courant en niveaux de gris dans différentes configurations d'utilisation du transistor T. Pour les figures 19, 20, 22, et 24, la densité de courant CD est exprimée en A/cm² et la teinte de gris est d'autant plus foncée que la densité de courant prend des valeurs extrêmes hautes ou extrêmes basses. Pour les figures 20, 22, et 24, la densité de courant CD est exprimée en A/cm². Les figures 21 et 23 représentes des équipotentielles dans différentes configurations d'utilisation du transistor T. Sur les figures 21 et 23, la concentration de dopants est en outre représentée en niveaux de gris, la teinte de gris est d'autant plus foncée que la concentration de dopants de type N ou P est élevée.

Les figures 18 à 20 illustrent une première simulation dans laquelle le transistor T est à l'état passant. Le drain du transistor T était à un potentiel d'environ 40 V, la tension entre la grille et la source du transistor T était d'environ 10 V, et le potentiel à la source du transistor T était d'environ 40 V. Une résistance à l'état passant Ron sensiblement égale à 6,3 mohms.mm² a été déterminée. La présence des zones de prise de contact 132 n'entraînent pas de dégradation excessive de la résistance à l'état passant Ron par rapport à une structure dans laquelle la région de source s'étendrait tout le long de la tranchée.

Les figures 21 et 22 illustrent une deuxième simulation dans laquelle le transistor T est à l'état non passant et les conditions de polarisation de la jonction P-N entre le caisson 130 et la région de dérive 142 sont les plus défavorables. Le drain du transistor T est à un potentiel d'environ 40 V, la tension entre la grille et la source du transistor T était d'environ 0 V, et le potentiel à la source du transistor T était d'environ 0 V. La jonction P-N formée entre le caisson 130 et la région de dérive 142 est polarisée en inverse et tient les potentiels appliqués.

Les figures 23 et 24 illustrent une troisième simulation dans laquelle les transistors T sont à l'état non passant et les conditions de polarisation de la jonction entre le caisson 130 et la région de dérive 152 sont les plus défavorables. Le drain de chaque transistor T était à un potentiel d'environ 0 V, la tension entre la grille et la source de chaque transistor T était d'environ 0 V, et le potentiel à la source de chaque transistor T était d'environ 17 V. La jonction P-N formée entre le caisson 130 et la région de dérive 152 est polarisée en inverse et tient les potentiels appliqués.

Les transistors T décrits précédemment permettent de façon avantageuse une tenue en tension à l'état non passant à la fois pour une tension drain-source positive et une tension drain-source négative.

Divers modes de réalisation et variantes ont été décrits. L'homme de l'art comprendra que certaines caractéristiques de ces divers modes de réalisation et variantes pourraient être combinées, et d'autres variantes apparaîtront à l'homme de l'art. En particulier, les transistors T ont été décrits avec une région de drain 140 située du côté de la face arrière. A titre de variante, la région de dérive 142 peut être au contact d'une zone de prise de contact plus dopée située du côté de la face avant.

Enfin, la mise en oeuvre pratique des modes de réalisation et variantes décrits est à la portée de l'homme du métier à partir des indications fonctionnelles données ci-dessus.

## Revendications

1. Dispositif électronique (100) comprenant un substrat semiconducteur (102) ayant une première face (104) et des transistors (T) dont les grilles (120) sont contenues dans des tranchées (110) s'étendant dans le substrat semiconducteur, chaque transistor comprenant, dans le substrat semiconducteur, un caisson semiconducteur (130) dopé d'un premier type de conductivité, dans lequel se forme en fonctionnement le canal du transistor, le caisson étant enterré dans le substrat semiconducteur et au contact de deux tranchées adjacentes parmi lesdites tranchées, une première région semiconductrice (152) dopée d'un deuxième type de conductivité, opposé au premier type de conductivité, recouvrant le caisson, au contact du caisson, et au contact des deux tranchées adjacentes, une deuxième région semiconductrice (150) dopée du deuxième type de conductivité plus fortement dopée que la première région semiconductrice, s'étendant dans la première région semiconductrice et exposée sur la première face, et une troisième région semiconductrice (132) dopée du premier type de conductivité, plus fortement dopée que le caisson, recouvrant le caisson, exposée sur la première face, au contact de la première région, et s'étendant dans le substrat semiconducteur au contact du caisson.

2. Dispositif électronique selon la revendication 1, dans lequel la deuxième région semiconductrice (150) est au contact des deux tranchées adjacentes.

3. Dispositif électronique selon la revendication 1 ou 2, dans lequel la troisième région semiconductrice (132) est au contact des deux tranchées adjacentes.

4. Dispositif électronique selon l'une quelconque des revendications 1 à 3, dans lequel la première région semiconductrice (152) comprend une première sous-région semiconductrice (154) contenant la deuxième région semiconductrice (150) et au moins une deuxième sous-région semiconductrice (156) exposée sur la première face (104) et reliant la première sous-région semiconductrice à la troisième région semiconductrice (132), la profondeur maximale de la première sous-région semiconductrice étant supérieure à la profondeur maximale de la deuxième sous-région semiconductrice.

5. Dispositif électronique selon l'une quelconque des revendications 1 à 4, dans lequel chaque transistor (T) comprend, dans la tranchée (110) contenant la grille (120) du transistor :
- une première couche isolante électriquement (124) entre la grille (120) du transistor et le caisson semiconducteur (130) et formant l'isolant de grille du transistor ;
- un élément conducteur électriquement (180) situé dans la tranchée (110) ;
- une deuxième couche isolante électriquement (184) entre l'élément conducteur électriquement et le substrat semiconducteur ; et
- une troisième couche isolante électriquement (186) entre l'élément conducteur électriquement et la grille.

6. Dispositif électronique selon l'une quelconque des revendications 1 à 5, dans lequel les deuxièmes régions semiconductrices (150) des transistors (T) sont connectées électriquement ensemble et dans lequel les troisièmes régions semiconductrices (132) des transistors (T) sont connectées électriquement ensemble.

7. Dispositif électronique selon l'une quelconque des revendications 1 à 6, dans lequel le substrat semiconducteur (102) comprend une deuxième face (106) opposée à la première face (104), chaque transistor comprenant en outre, dans le substrat semiconducteur, une quatrième région semiconductrice (142) dopée du deuxième type de conductivité, recouverte par le caisson (130), au contact du caisson, et une cinquième région semiconductrice (150) dopée du deuxième type de conductivité, plus fortement dopée que la quatrième région semiconductrice, et exposée sur la deuxième face.

8. Dispositif électronique selon l'une quelconque des revendications 1 à 7, comprenant plusieurs transistors (T) pour chaque paire de tranchées (110) adjacentes, au moins certaines des troisièmes régions semiconductrices (132) des transistors étant alternés avec les deuxièmes régions semiconductrices (150) des transistors.

9. Dispositif électronique selon la revendication 8, dans lequel les caissons (130) de deux transistors (T) adjacents sont jointifs.

10. Procédé de fabrication du dispositif électronique (100) selon l'une quelconque des revendications 1 à 9, dans lequel la formation de la première région semiconductrice (152) comprend une étape de formation, par épitaxie, d'une couche semiconductrice (210) dopée du deuxième type de conductivité, et une étape d'implantation de dopants du deuxième type de conductivité dans la couche semiconductrice.
